# EUROPEAN PATENT SPECIFICATION

(11) **EP 3 170 209 B1**
(45) Date of publication and mention of the grant of the patent: **12.12.2018**
(21) Application number: 15748100.3
(22) Date of filing: 17.07.2015
(51) Int. Cl.: H01L 31/0224, H01L 31/074, H01L 31/0747

(54) **SOLAR CELL WITH INTERDIGITATED BACK CONTACT**
SOLARZELLE MIT VERFINGERTEM RÜCKSEITENKONTAKT
CELLULE SOLAIRE À CONTACT ARRIÈRE INTERDIGITÉ

(30) Priority: 17.07.2014 US 201462025924 P
(43) Date of publication of application: 24.05.2017
(73) Proprietor: Tesla, Inc., Palo Alto, CA 94304 (US)
(72) Inventor: HENG, Jiunn Benjamin, Los Altos Hills, California 94022 (US); XIE, Zhigang, San Jose, California 95135 (US); XU, Zheng, Pleasanton, California 94588 (US)
(74) Representative: Bryn-Jacobsen, Caelia
(86) International application number: PCT/US2015/041027
(87) International publication number: WO 2016/011426

(56) References cited:
- US-A1- 2008 061 293
- US-A1- 2012 285 517
- US-A1- 2013 269 771
- TOMASI ANDREA ET AL: "Back-Contacted Silicon Heterojunction Solar Cells With Efficiency >21%", IEEE JOURNAL OF PHOTOVOLTAICS, I E E E, US, vol. 4, no. 4, 1 July 2014 (2014-07-01), pages 1046-1054, XP011551583, ISSN: 2156-3381, DOI: 10.1109/JPHOTOV.2014.2320586 [retrieved on 2014-06-18]

## Description

### FIELD OF THE INVENTION

This relates to solar cell structure and fabrication, including the design of a solar cell with tunneling oxide junctions and interdigitated back contacts, and the fabrication process of such a solar cell.

### DEFINITIONS

"Solar cell" or "cell" is a photovoltaic structure capable of converting light into electricity. A cell may have any size and any shape, and may be created from a variety of materials. For example, a solar cell may be a photovoltaic structure fabricated on a silicon wafer or one or more thin films on a substrate material (e.g., glass, plastic, or any other material capable of supporting the photovoltaic structure), or a combination thereof.

A "solar cell strip," "photovoltaic strip," or "strip" is a portion or segment of a photovoltaic structure, such as a solar cell. A solar cell may be divided into a number of strips. A strip may have any shape and any size. The width and length of a strip may be the same or different from each other. Strips may be formed by further dividing a previously divided strip.

A "cascade" is a physical arrangement of solar cells or strips that are electrically coupled via electrodes on or near their edges. There are many ways to physically connect adjacent photovoltaic structures. One way is to physically overlap them at or near the edges (e.g., one edge on the positive side and another edge on the negative side) of adjacent structures. This overlapping process is sometimes referred to as "shingling." Two or more cascading photovoltaic structures or strips can be referred to as a "cascaded string," or more simply as a string.

"Finger lines," "finger electrodes," and "fingers" refer to elongated, electrically conductive (e.g., metallic) electrodes of a photovoltaic structure for collecting carriers.

A "busbar," "bus line," or "bus electrode" refers to an elongated, electrically conductive (e.g., metallic) electrode of a photovoltaic structure for aggregating current collected by two or more finger lines. A busbar is usually wider than a finger line, and can be deposited or otherwise positioned anywhere on or within the photovoltaic structure. A single photovoltaic structure may have one or more busbars.

A "photovoltaic structure" can refer to a solar cell, a segment, or solar cell strip. A photovoltaic structure is not limited to a device fabricated by a particular method. For example, a photovoltaic structure can be a crystalline silicon-based solar cell, a thin film solar cell, an amorphous silicon-based solar cell, a poly-crystalline silicon-based solar cell, or a strip thereof.

A "front side" of a photovoltaic structure refers to the side of the structure that is typically used to absorb direct sunlight.

A "back side" of a photovoltaic structure refers to the side of the structure that is typically facing away from direct sunlight.

An "emitter" refers to a part of a photovoltaic structure that collects carriers, either holes or electrons. An emitter can also be referred to as a surface field (SF) layer, which can be a back surface field (BSF) layer or a front-surface field (FSF) layer, if such an emitter has the same conductivity type as that of the base layer. In general, a p emitter collects holes generated by the solar cell (i.e., it "emits" p-type carrier, or holes, to an external circuit) and an n emitter collects electrons (i.e., it "emits" n-type carrier, or electrons, to an external circuit). Hence, a p emitter may also be called a hole collector, and an n emitter may also be called an electron collector.

### Related Art

Advances in photovoltaic technology, which are used to make solar panels, have helped solar energy gain mass appeal among those wishing to reduce their carbon footprint and decrease their monthly energy costs. The energy conversion efficiency of photovoltaic structures has always been the focus of solar technology development. The latest photovoltaic structure designs have produced solar cells with efficiencies of 20% or higher, while the pursuit for more efficient devices continues.

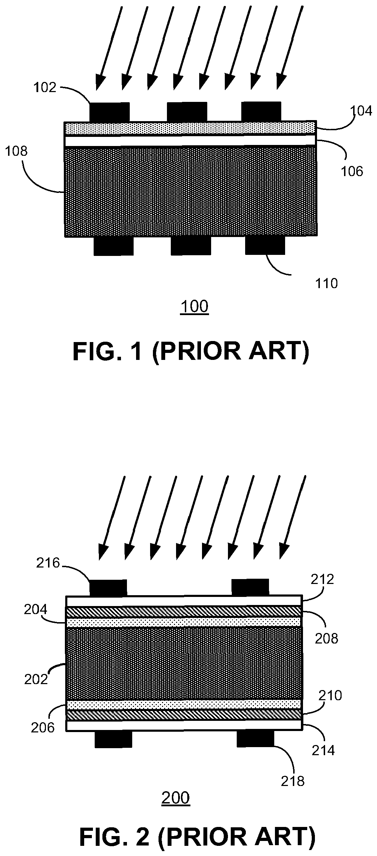

FIG. 1 shows an exemplary silicon heterojunction (SHJ) solar cell (prior art). SHJ solar cell 100 can include front grid electrode 102, heavily doped amorphous-silicon (a-Si) emitter layer 104, intrinsic a-Si layer 106, crystalline-Si (c-Si) substrate 108, and back grid electrode 110. Arrows in FIG. 1 indicate direct incident sunlight. Because there is an inherent bandgap offset between a-Si layer 106 and c-Si layer 108, a-Si layer 106 can be used to reduce the surface recombination velocity by creating a barrier for minority carriers. Intrinsic a-Si layer 106 can also passivate the surface of c-Si layer 108 by repairing the existing Si dangling bonds. Moreover, the thickness of heavily doped a-Si emitter layer 104 can be much thinner compared with that of a homojunction solar cell. Thus, SHJ solar cells can provide a higher efficiency with higher open-circuit voltage (V_{oc}) and larger short-circuit current (J_{sc}). The efficiency of such a solar cell, however, is limited by the amount of shading caused by front-side electrode 102. One approach to address this limitation is to have both p-type and n-type electrodes on the back side of the photovoltaic structure. Nevertheless, such a configuration requires complex fabrication steps, and prevents the solar cell from absorbing light from the back side.

US 2013/269771 A1 discloses a solar cell including a substrate of a first conductive type, an emitter region which is positioned at a first surface of the substrate and has a second conductive type different from the first conductive type, a first surface field region which is positioned at the first surface of the substrate and separated from the emitter region, a first auxiliary electrode positioned directly on the emitter region, a second auxiliary electrode positioned directly on the first surface field region, a first main electrode positioned directly on the first auxiliary electrode, and a second main electrode positioned directly on the second auxiliary electrode. Each of the first and second auxiliary electrodes is a transparent conductive layer formed by doping a transparent conductive oxide layer with a conductive material.

### SUMMARY

The present invention is set out in the independent claims, with some optional features set out in the claims dependent thereto.

One embodiment of the present invention provides a solar cell with an interdigitated back contact. The solar cell can include a crystalline silicon base layer and an electron collector region on a back side of the base layer. The electron collector region can include a first conductive oxide material electrically coupled to the base layer. The solar cell can also include a hole collector region on the back side of the base layer. The hole collector region can include a second conductive oxide material electrically coupled to the base layer. The electron collector region and hole collector region can form an interdigitated pattern. Furthermore, the first conductive oxide material and second conductive oxide material have different work functions.

In a variation on the embodiment, the solar cell can include a quantum-tunneling-barrier layer between the base layer and the electron collector region.

In a further embodiment, the solar cell can include an intrinsic amorphous silicon layer between the quantum-tunneling-barrier layer and the electron collector region.

In a variation on this embodiment, the electron collector region or hole collector region does not contain doped amorphous silicon.

In a variation on this embodiment, at least one of the first conductive oxide material and second conductive oxide material is transparent.

In a variation on this embodiment, the base layer can be doped with p-type dopants. The first conductive oxide material can have a work function that is less than or equal to 4.2 eV.

In a further variation, the first conducting oxide material includes at least one material selected from a group consisting of: aluminum doped zinc oxide, tungsten doped indium oxide, tin doped indium oxide, fluorine doped tin oxide, zinc doped indium oxide, and zinc and tungsten doped indium oxide.

In a variation on this embodiment, the base layer is doped with n-type dopants. The first conductive oxide material can have a work function that is greater than or equal to 5.0 eV.

In a further variation, the first conducting oxide material can include at least one material selected from a group consisting of: tungsten doped indium oxide, tin doped indium oxide, gallium indium oxide, gallium indium tin oxide, zinc indium oxide, zinc indium tin oxide, tungsten oxide, titanium doped indium oxide, cerium oxide, manganese oxide, and indium oxide.

In another embodiment, the electron collector region and hole collector region are at least partially transparent, thereby allowing the solar cell to absorb light from the back side.

### BRIEF DESCRIPTION OF THE FIGURES

FIG. 1 shows an exemplary silicon hetero junction solar cell (prior art).
FIG. 2 shows an exemplary double-sided tunneling junction solar cell (prior art).
FIG. 3 shows an exemplary tunneling-oxide interdigitated back contact (TIBC) solar cell, according to an embodiment of the present invention.
FIG. 4 shows an exemplary TIBC solar cell, according to an embodiment of the present invention.
FIG. 5A shows band diagram between crystalline-Si and a conductive oxide material, according to an embodiment of the present invention.
FIG. 5B shows band diagram between crystalline-Si and a conductive oxide material, according to an embodiment of the present invention.
FIG. 6A shows band diagram between crystalline-Si and a conductive oxide material, according to an embodiment of the present invention.
FIG. 6B shows band diagram between crystalline-Si and a conductive oxide material, according to an embodiment of the present invention.
FIG. 6C shows band diagram between crystalline-Si and a conductive oxide material, according to an embodiment of the present invention.
FIG. 7 shows an exemplary layout of a TIBC solar cell, according to an embodiment of the present invention.
FIG. 8A shows an exemplary layout of a TIBC solar cell, according to an embodiment of the present invention.
FIG. 8B shows an exemplary cascade of TIBC solar cell strips, according to an embodiment of the present invention.
FIG. 9 shows an exemplary process of fabricating a TIBC solar cell, according to an embodiment of the present invention.

In the figures, like reference numerals refer to the same figure elements.

### DETAILED DESCRIPTION

The following description is presented to enable any person skilled in the art to make and use the embodiments, and is provided in the context of a particular application and its requirements. Various modifications to the disclosed embodiments will be readily apparent to those skilled in the art, and the general principles defined herein may be applied to other embodiments and applications without departing from the spirit and scope of the present disclosure. Thus, the present invention is not limited to the embodiments shown, but is to be accorded the widest scope consistent with the principles and features disclosed herein.

### Overview

Embodiments of the present invention solve the problem of front-side electrode shading on a solar cell by providing a tunneling-junction solar cell with interdigitated back contacts. The solar cell can include a lightly doped base layer with its front- and back side covered with a thin layer of silicon oxide serving as a quantum-tunneling-barrier (QTB) layer. An electron collector region and hole collector region, often formed in finger-like shapes, form an interdigitated pattern on the back side of the solar cell. Electron-collecting and hole-collecting electrodes can then be formed on the electron collector region and hole collector region, respectively. These electrodes can in turn form the interdigitated back contact (IBC) for the solar cell. The electron collector region can include p-type doped hydrogenated a-Si or conductive oxide (CO) with a sufficiently low work function. The hole collector region can include n-type doped a-Si or CO with a sufficiently high work function. Using conductive oxide materials with properly tuned work functions can obviate the need of using doped a-Si materials as electron and hole collectors, respectively. Furthermore, the back side of the solar cell can be entirely or partially covered by transparent conductive oxide (TCO) material, which allows the solar cell to operate in a bi-facial mode and absorb light from both the front side and back side.

To improve passivation, a thin layer of intrinsic a-Si can be positioned between the back side QTB layer and the electron and hole collector regions. In addition, the electrodes can be based on copper and formed using electroplating, physical vapor deposition, or a combination thereof. Because all electrical connections are on the back side of the solar cell, and because the back side of the cell can now be transparent, the tunneling junction solar cells with IBCs can absorb light from both front and back sides, which results in higher efficiency. Moreover, the IBC configuration can facilitate more efficient module fabrication and modules with a higher packing factor, because it is no longer necessary to weave the connecting tabs from one side of a solar cell to the other side of an adjacent solar cell.

### Tunneling-oxide Interdigitated Back Contact (TIBC) Solar Cell

It has been shown that a special type of SHJ solar cell (i.e., tunneling junction solar cells) can provide superior performance because the quantum-tunneling barrier (QTB) layers can effectively passivate the surfaces of the base layer without compromising the carrier collection efficiency. The tunneling junction can be located at either or both sides of the solar cell. FIG. 2 shows an exemplary double-sided tunneling junction solar cell. Double-sided tunneling junction solar cell 200 can include base layer 202 and quantum tunneling barrier (QTB) layers 204 and 206, which cover both sides of base layer 202 and can passivate the surface-defect states. Solar cell 200 further includes a front-side doped a-Si layer as front surface field (FSF) layer 208, a back-side doped a-Si layer as emitter layer 210, front transparent conducting oxide (TCO) layer 212, back TCO layer 214, front metal grid 216, and back metal grid 218. Note that depending on the doping type of base layer 202, FSF layer 208 and emitter 210 may be of different doping types. In general, an "emitter" can also refer to a layer that has a doping type opposite to that of the base layer, so that the majority carrier generated in the base layer can be effectively collected. A surface field layer (either on the front side or back side of the base layer) can have the same doping type as the base layer to collect the minority carriers generated in the base layer. For example, if base layer 202 is n-type doped, emitter 208 can be p-type doped, and FSF layer 208 can be n-type doped. Similarly, if base layer 202 is p-type doped, emitter 208 can be n-type doped, and FSF layer 208 can be p-type doped.

The ultrathin tunneling oxide layers (e.g., QTB layers 204 and 206) deposited on either or both sides of the base layer can result in low interface defect density (Dᵢₜ), which can be less than 1×10¹¹ /*cm*²*,* without significantly increasing the series resistance associated due to the tunneling effect through quantum barrier. As a result, a high efficiency solar cell with open-circuit voltage (V_{oc}) greater than 715 mV can be achieved. Details, including fabrication methods, about double-sided tunneling junction solar cell 200 can be found in U.S. Patent No. 8,686,283, entitled "Solar Cell with Oxide Tunneling Junctions," by inventors Jiunn Benjamin Heng, Chentao Yu, Zheng Xu, and Jianming Fu, filed 12 November 2010, the disclosure of which is incorporated by reference in its entirety herein.

Note that it is also possible to have the emitter layer on the front side and a back surface field (BSF) layer on the back side of the solar cell to achieve a back junction solar cell with improved performance. Placing the emitter (i.e., majority carrier collector) on the back side, however, can have certain advantages. For example, for an n-type doped base layer, placing the heavily p-type doped emitter with higher defect density on the back side can reduce absorption of short-wavelength light near the front surface of the solar cell. Also, when placed on the back side, the p-type doped emitter can be relatively thick to eliminate the emitter depletion effect without incurring excessive short wavelength absorption. As a result of reduction of of carrier depletion, the cell's open circuit voltage and fill factor can improve. In addition, the back junction structure can provide more flexibility to tune the p-type doped emitter's work function to match the work function of the back TCO material better, and/or allow better-matched back side TCO material without being limited by the TCO material's optical transmission properties. Moreover, because the back junction can be mostly impacted by long wavelength, low energy absorption, it is less affected by high energy, excessive carrier junction recombination. Details, including fabrication methods, about a back junction solar cell with tunnel oxide can be found in U.S. Patent Application No. 13/601,441 (Attorney Docket No. SCTY-P52-2NUS), entitled "Back Junction Solar Cell with Tunnel Oxide," by inventors Jiunn Benjamin Heng, Jianming Fu, Zheng Xu, and Zhigang Xie, filed 31 August 2012, the disclosure of which is incorporated by reference in its entirety herein.

Despite providing many benefits, the back junction solar cells with tunnel oxide still might still exhibit certain shortcomings. For example, there can be inherent loss of current because the back junction structure requires a longer diffusion length to allow the excess carriers to be swept across by the built-in potential at the back junction.

In order to further improve the performance of the back junction solar cells with tunnel oxide, in some embodiments of the present invention, interdigitated back contact (IBC) is incorporated into such a back junction solar cell to form a tunneling-oxide interdigitated back contact (TIBC) solar cell. The IBC can eliminate the need for front-side electrodes, which cause shading in conventional solar cells, thus improving the solar cell performance by increasing short circuit current (I_{sc}). In addition, compared with other conventional IBC-based solar cells, the TIBC solar cells have enhanced V_{oc} because the tunneling oxide layer can improve passivation on the rear positive and negative electrodes. In some embodiments, an intrinsic a-Si layer can be inserted between the tunneling oxide layer and the electron and hole collector layer to facilitate better passivation and separation between the electron and hole collector regions, which can lead to improved V_{oc} and fill factor.

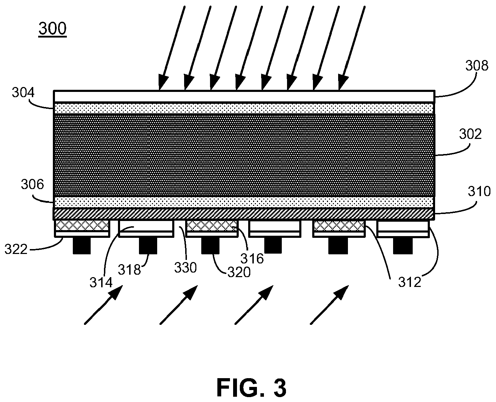

FIG. 3 shows an exemplary TIBC solar cell, according to an embodiment of the present invention. Solar cell 300 includes base layer 302, front QTB layer 304, back QTB layer 306, anti-reflection coating (ARC) layer 308, optional intrinsic a-Si layer 310, carrier collector layer 312 that includes electron collectors (also referred to as n emitter) and hole collectors (also referred to as p emitters) that can form an interdigitated pattern (such as n emitter 314 and p emitter 316), and a number of electrodes (such as electrodes 318 and 320). The arrows indicate incident light.

Base layer 302 may include a layer of c-Si that is epitaxially grown or a c-Si wafer cut from an ingot obtained via the Czochralski (CZ) or floating zone (FZ) process and is lightly doped with either n-type or p-type dopants. The thickness of base layer 302 can be between 80 and 200 µm. In some embodiments, the thickness of base layer 302 is between 80 and 120 µm. The resistivity of base layer 302 can be between 1 ohm-cm and 10 ohm-cm. In one embodiment, the resistivity of base layer 302 is between 1 ohm-cm and 5 ohm-cm, and the bulk minority carrier lifetime (MCL) is at least 1 ms. In a further embodiment, base layer 302 can be graded-doped with n-type dopants, and can include a textured surface.

QTB layers 304 and 306 can be in direct contact with base layer 302, and can include a dielectric thin film and/or a layer of wide bandgap semiconductor material with low or no doping. Exemplary materials used for the dielectric thin film include, but are not limited to: silicon oxide (SiOₓ), hydrogenated SiOₓ, silicon nitride (SiNₓ), hydrogenated SiNₓ, silicon oxynitride (SiON), hydrogenated SiON, aluminum oxide (AlOₓ or Al₂O₃), and aluminum nitride (AlNₓ). Examples of the wide bandgap materials include, but are not limited to: amorphous Si (a-Si), hydrogenated a-Si, carbon doped a-Si, and silicon carbide (SiC). In one embodiment, back QTB layer 306 can include SiOₓ, such as SiO or SiO₂, and/or hydrogenated SiOₓ. Front QTB layer 304 can include one or more of: intrinsic a-Si, amorphous SiO, SiOₓ, SiNₓ, and Al₂O₃. The SiOₓ or hydrogenated SiOₓ layer can be formed using various oxidation techniques, such as submerging the wafer in hot deionized water (DIW), low-pressure radical oxidation, ozone oxygen oxidation, atomic oxygen oxidation, thermal oxidation, chemical oxidation, steam or wet oxidation, atomic layer deposition, ozone bubbling in DIW, and plasma-enhanced chemical-vapor deposition (PECVD). The thickness of QTB layers 304 and 306 can be between 1 and 20 angstroms. In one embodiment, QTB layers 304 and 306 can each include a SiOₓ layer having a thickness between 8 and 15 angstroms. In some embodiments, the Dᵢₜ of QTB layers 304 and 306 can be less than 5×10¹¹ /*cm*²*.*

ARC layer 308 can be deposited on front QTB layer 304 to maximize the amount of light absorbed by solar cell 300. In some embodiments, ARC layer 308 can include one or more of: transparent conductive oxide (TCO), SiNₓ, SiOₓ, and AlₓO₃.

Intrinsic a-Si layer 310 can be deposited on back QTB layer 306. In some embodiments, the thickness of intrinsic a-Si layer 310 can range between 5 Å and 100 Å. In a further embodiment, the thickness of intrinsic a-Si layer 310 is approximately 30 Å. Intrinsic a-Si layer 310 can be deposited using a plasma-enhanced chemical-vapor deposition (PECVD) technique. Optional intrinsic a-Si layer 310 can further reduce minority carrier recombination.

Carrier collector layer 312 can include interdigitated-patterned (e.g., interleaved, parallel fingers) p emitters and n emitters. More specifically, n emitters, such as emitter 314, can include p-type doped a-Si, and can be in contact with intrinsic a-Si layer 310. In some embodiments, the n emitters can include hydrogenated a-Si with a graded doping profile. If base layer 302 is n-type doped, the n emitters can have the opposite electrical conductivity type to base layer 302. The p-type doped a-Si layer, intrinsic a-Si layer 310, QTB layer 306, and base layer 302 together form a hetero tunneling back junction. In some embodiments, the n emitters (which have an opposite conductivity type to that of n-type doped base layer 302) can have a thickness between 3 and 20 nm and a doping concentration between 1×10¹⁵ /*cm*³ and 5×10²⁰ /*cm*³*.* Such doped and sufficiently thick n emitters can ensure a good ohmic contact and large built-in potential to facilitate a strong tunneling effect.

Similarly, p emitters, such as emitter 316, can include n-type doped a-Si, and be in contact with intrinsic a-Si layer 310. In some embodiments, the p emitters can include hydrogenated a-Si with a graded doping profile. If base layer 302 is n-type doped, the p emitters have the same electrical conductivity type to base layer 302. In some embodiments, the p emitters can have a thickness between 1 and 30 nm and a doping concentration between 1×10¹⁵ /*cm*³ and 5×10²⁰ /*cm³.* The interdigitated pattern can facilitate multiple p emitter contacts to the underlying intrinsic a-Si layer 310 and QTB layer 306. The interdigitated pattern of both the n and p emitters allows adjacent emitters have opposite conductivity doping types. Forming the emitters often involves epitaxially growing doped Si over one or more patterned masks, and hence carefully designed masks can ensure gaps of appropriate size are maintained between the emitters of opposite doping types. This prevents the formation of a short circuit between electrodes of opposite polarities.

Electrodes deposited on the p-type and n-type emitters, such as electrodes 318 and 320, provide electrical coupling to the emitters. As shown in FIG. 3, there can be gaps between adjacent emitters of opposite doping types to ensure that the electrodes are not shorted. For example, p-type emitter 314 and n-type emitter 316 are separated by gap 330, which ensures that electrodes 318 and 320 are sufficiently isolated from each other.

In some embodiments, conductive oxide (CO) layer 322 can be formed between carrier collector layer 312 and the electrode metallic layer. CO layer 322 can facilitate the formation of good ohmic contact to the p-type and n-type emitters. In some embodiments, CO layer 322 can include one or more transparent conductive oxide (TCO) materials. As a result, the back side of solar cell 300 can be transparent, either entirely or partially, in areas not covered by the electrodes. Using TCO allows solar cell 300 to receive and absorb light incident upon its back side, which in turn allows solar cell 300 to operate in a bi-facial mode.

CO layer 322 can be deposited using one or more of the following techniques: plasma vapor deposition, thermal evaporation, ion plating, and remote plasma deposition. The metallic layer can be deposited on CO layer 322 or directly on the p-type or n-type doped a-Si. In some embodiments, the metallic layer can include one or more layers of metal, such as Cu, Ag, Ni, etc. Various techniques, including but not limited to: physical vapor deposition (PVD), screen printing, evaporating, inkjet printing, aerosol printing, electro- or electroless plating with patterning can be used to deposit the one or more metallic layers. In one embodiment, the metallic electrodes can include copper, and can be formed using an electroplating technique. In a further embodiment, a seed layer of copper can be deposited using a PVD process, and bulk copper can be formed on the seed layer using an electroplating process. More details on how to form an electroplated metal grid on a photovoltaic structure can be found in U.S. Patent Application No. 13/220,532, entitled "SOLAR CELL WITH ELECTROPLATED METAL GRID," by inventors Jianming Fu, Zheng Xu, Chentao Yu, and Jiunn Benjamin Heng, the disclosure of which is incorporated by reference in its entirety herein.

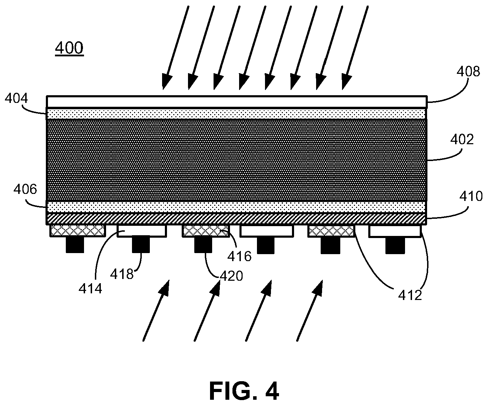

Instead of using a-Si based emitters, in some embodiments of the present invention, the n or p emitters can be formed using CO materials (which can be transparent or opaque), without using any doped a-Si material. FIG. 4 shows an exemplary TIBC solar cell according an embodiment of the present invention. Solar cell 400 includes base layer 402, front QTB layer 404, back QTB layer 406, anti-reflection coating (ARC) layer 408, optional intrinsic a-Si layer 410, CO layer 412. CO layer 412 can include high work function CO regions that function as hole collectors and low work function CO regions that function as electron collectors. These two CO regions of different work functions form the interdigitated pattern (such as low work function CO region 414 (electron collector) and high work function CO region 416 (hole collector)). A number of metallic electrodes (such as metallic electrodes 418 and 420) can be formed on CO layer 142.

Base layer 402, front and back QTB layers 404 and 406, ARC layer 408, and intrinsic a-Si layer 410 can be similar to base layer 302, front and back QTB layers 304 and 306, ARC layer 308, and intrinsic a-Si layer 310, respectively. However, instead of graded doped a-Si, CO layer 412 (which can include two types of CO materials deposited in two or more steps) can be deposited onto and in direct contact with intrinsic a-Si layer 410 or back QTB layer 406 (if a-Si layer 410 is not present). As shown in FIG. 4, CO layer 412 includes low work function CO regions, such as CO region 414, and high work function CO regions, such as CO region 416. Both the high work function CO regions and low work function CO regions can be interleaved in an interdigitated pattern. Metallic electrodes 418 and 420 can be similar to metallic electrodes 318 and 320.

As mentioned above, to collect holes, instead of using n-type doped a-Si, a high work function CO material can be used. Ideally, this high work function CO material has a work function whose absolute value is within a small range (e.g., 0.3 eV) near or greater than the value of the valence band edge, Eᵥ, of the c-Si (lightly doped or intrinsic) used in base layer 402, which is approximately 5.17 eV. When interfaced with c-Si base layer 402, this high work function CO region (such as CO region 416) can create a built-in electrical field that can draw the holes away from base layer 402 where carriers (i.e., both electrons and holes) are generated. Because the CO material's work function is sufficiently large, the potential difference at this interface is sufficiently large to cause the holes to tunnel through back side QTB layer 406. If base layer 402 is n-type doped, this high work function CO layer can function as a surface field region, because it attracts minority carriers (i.e., holes). If base layer 403 is p-type doped, this high work function CO layer can function as an emitter region, because it attracts majority carriers (i.e., holes).

Similarly, to collect electrons, instead of using p-type doped a-Si, a low work function CO material can be used. Ideally, this low work function CO material has a work function whose absolute value is within a small range (e.g., 0.1 eV to 0.3 eV) near or less than the value of the conduction band edge of the c-Si (lightly doped or intrinsic) used in base layer 402. When interfaced with c-Si base layer 402, this low work function CO region (such as CO region 414) can create a built-in electrical field that can draw the electrons away from base layer 402. Because the CO material's work function is sufficiently small, the potential difference at this interface is sufficiently large to cause the electrons to tunnel through back side QTB layer 406. If base layer 402 is n-type doped, this low work function CO layer can function as an emitter, because it attracts majority carriers (i.e., electrons). If base layer 402 is p-type doped, this low work function CO layer can function as a surface field region, because it attracts minority carriers (i.e., electrons).

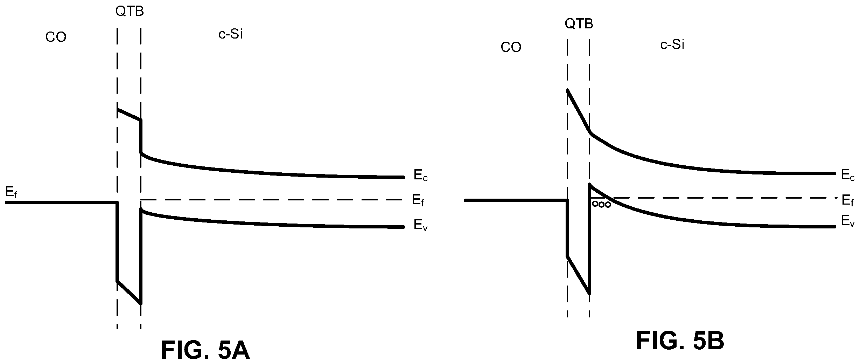

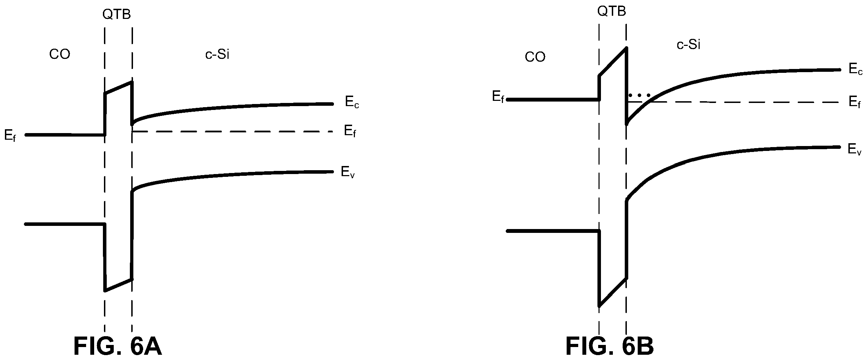

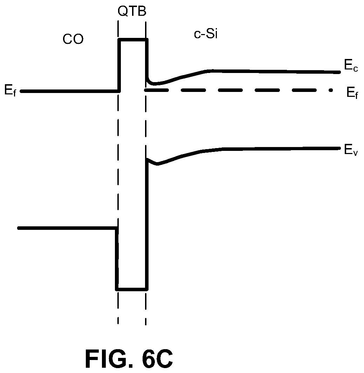

Furthermore, because of the passivation effect of intrinsic a-Si layer 410, the CO film can be formed with a low interface defect density. In one embodiment, the interface defect density (Dᵢₜ) can be less than 1e¹¹/cm², which makes it possible to eliminate the Fermi-level pinning effect at the CO-semiconductor interface. The Fermi-level pinning effect can be caused by the surface states associated with the defects and would make energy band bending nearly impossible on the semiconductor side. As a result of Fermi-level pinning, the Schottky barrier height can be insensitive to the conductor's (which in this case is the CO material) work function. Because of the low interface defect density resulting from intrinsic a-Si layer 410, the carrier transportation property can now be manipulated based on Fermi level of the CO layer. Consequently, the degenerated carrier distribution in the CO layer with an appropriate work function and the low Dᵢₜ make it possible to have a strong tunneling effect when the CO/intrinsic a-Si/QTB structure is in contact with a lightly doped c-Si base. The tunneling process can depend on the available carrier concentration at the starting side (the c-Si side) and the density of states at the receiving side (the CO side), according to the Wentzel-Kramers-Brillouin (WKB) approximation. As explained in more detail below in conjunction with FIGs. 5A, 5B, 6A, 6B, and 6C, strong tunneling can be present in two different situations depending on the different work functions of the CO materials.

In one embodiment, when CO materials with different work functions are used as electron and hole collectors instead of p-type and n-type doped a-Si, the CO materials can be transparent, opaque, or partially transparent. In one embodiment, the high work function and low work function CO materials are transparent (i.e., both are TCO materials). As a result, the solar cell can absorb light from both front side and back side. Such solar cells can then be used to build bi-facial solar panels, which can produce more energy than a conventional single-sided solar panel.

FIG. 5A shows a band diagram at the interface between crystalline-Si and a CO material with a work function close to the Si valence band edge. In FIG. 5A, the work function of the CO material is close to the c-Si valence band edge (the difference is within 0.1 eV). When the CO material is interfaced with the c-Si base layer through the QTB layer, the Fermi levels of the CO material and c-Si should be aligned to maintain electrical neutrality. As a result, the energy band on the c-Si side bends upwards, and a potential difference appears between the c-Si's valence band (where holes created by the solar cell are at, as a result of electrons in the valence band being excited to the conduction band), the holes would migrate toward the CO region though the QTB due to the tunneling effect. Depending on the doping type of the lightly doped c-Si, there might be hole accumulation (if the c-Si is p-type doped) or carrier inversion (if the c-Si is n-type doped) at the interface, and the highest hole concentration can be close to the doping concentration in the CO material (e.g., approximately 1×10²⁰/cm³). As shown in FIG. 5A, there is band bending at the QTB/Si interface, pushing the Fermi level closer to the valence band edge (Eᵥ) of the c-Si. Because the band offset between c-Si and the CO can be fairly small, and considering the thermal broadening, the tunneling effect can be strong.

FIG. 5B shows a band diagram at the interface between c-Si and a CO material that has a work function considerably larger than the c-Si valence band edge, according to an embodiment of the present invention. In FIG. 5B, the work function of the CO material is considerably larger than the c-Si valence band edge, which is approximately 5.17 eV. At the QTB/Si interface, the slope for the band bending can be sufficiently big that a quantum well for holes appears. The lowest energy level for the heavily degenerated holes on the Si side, hence, is not at the valence band edge, but is the first confinement energy level, which can be 0.1 eV above the valence band edge (as shown by the circles in FIG. 5B). In addition, heavy holes and light holes have different masses and energy states. As a result, it is relatively easy to achieve energy level alignment, which is required due to the energy conservation requirement for the intra-band tunneling of the holes. Electrons, on the other hand, will be repelled by the barrier. There will be no tunneling of the electrons because the receiving side is within the forbidden band.

Note that, if the work function of the CO material is much less than the c-Si valence band edge, there might not be sufficient band bending, and thus insufficient tunneling through the QTB layer.

In some embodiments, the high work function CO materials can include, but are not limited to: tungsten doped indium oxide (IWO), Sn doped indium oxide (ITO), GaInO (GIO), GaInSnO (GITO), ZnInO (ZIO), ZnInSnO (ZITO),WOₓ, MnOₓ, ITiO, InO, CeO and their combinations. The work function of most CO materials can be tuned by adjusting the carrier concentration and doping. For example, ITO with 3% or 5% Sn has a work function between 5.0 and 5.3 eV. In addition, one can control the CO work function by controlling the crystalline orientation and surface condition. To ensure sufficiently low Dᵢₜ, in one embodiment, the CO layer is deposited on the intrinsic a-Si layer using a low-damage deposition method. Examples of low-damage deposition methods include, but are not limited to: radio frequency (RF) sputtering (with RF frequency of at least 13 MHz, preferably greater than 13.56 MHz), thermal evaporation, epitaxial growth such as molecular beam epitaxy (MBE) and metalorganic chemical-vapor deposition (MOCVD), atomic layer deposition (ALD), remote plasma deposition, and ion plating deposition (IPD). In one embodiment, the Dᵢₜ at the interface can be less than 1×10¹¹/cm², which ensures good surface passivation. The high work function CO layer can be heavily doped (with metal ions) with a doping concentration of at least 1×10¹⁹/cm³. In one embodiment, the doping concentration of the high work function CO layer can be greater than 2×10²⁰/cm³.

Details, including fabrication methods, about a solar cell with TCO-based hole collectors can be found in U.S. Patent Application No. 14/051,336, Attorney Docket No. P64-1NUS, entitled "NOVEL HOLE COLLECTORS FOR SILICON PHOTOVOLTAIC CELLS," by inventors Zhigang Xie, Jiunn Benjamin Heng, Wei Wang, Jianming Fu, Zheng Xu, filed 10 October 2013, the disclosure of which is incorporated by reference in its entirety herein.

Similarly, to collect electrons, instead of using p-type doped a-Si, a low work function CO material can be used. Ideally, this low work function CO material has a work function whose absolute value is within a small range (e.g,. 0.3 eV) near or smaller than the value of the conduction band edge, E_{c}, of the c-Si (lightly doped or intrinsic) used in the base layer. When interfaced with c-Si base layer 402, this low work function CO region (such as CO region 414) can create a built-in electrical field that can draw the electrons away from base layer 402, and hence function as an electron collector (or n emitter). Similar to that of the high work function regions, the low Dᵢₜ at the interface can reduce or eliminate the Fermi-level pinning effect, and the tunneling process depends on the available carrier concentration at the starting side (the c-Si side) and the density of states at the receiving side (the CO side). Based on the difference between the CO work function and the c-Si conduction band edge, there are three different situations when strong tunneling is present (described below).

Details, including fabrication methods, about a solar cell with TCO-based electron collectors can be found in U.S. Patent Application No. 14/054,688, Attorney Docket No. P65-1NUS, entitled "NOVEL ELECTRON COLLECTORS FOR SILICON PHOTOVOLTAIC CELLS," by inventors Zhigang Xie, Wei Wang, Jiunn Benjamin Heng, Jianming Fu, and Zheng Xu, filed 15 October 2013, the disclosure of which is incorporated by reference in its entirety herein.

There can be gaps between adjacent CO regions of different work functions to ensure that the electrodes are not shorted. For example, low work function CO region 414 and high work function CO region 416 can be separated by a gap to ensure that electrodes 418 and 420 are not shorted. The formation of the CO regions can involve PECVD over one or more patterned masks, and hence carefully designed masks can ensure gaps of appropriate size are maintained between the CO regions of different work functions.

FIG. 6A shows the band diagram at the interface between c-Si and a CO material with a work function that is slightly below the c-Si conduction band edge, according to an embodiment of the present invention. In FIG. 6A, the work function of the CO material is slightly below (the difference is within 0.1 eV) the c-Si conduction band edge. When the CO material is interfaced with the c-Si base layer through the QTB layer, the Fermi levels of the CO material and c-Si should be aligned to maintain electrical neutrality. As a result, the energy band on the c-Si side bends downwards, and a potential difference appears between the c-Si's conduction band (where electrons created by the solar cell are at), the electrons would migrate toward the CO region through the QTB due to the tunneling effect. Depending on the doping type of the lightly doped c-Si, there might be electron accumulation (if the c-Si is n-type doped) or carrier inversion (if the c-Si is p-type doped) at the interface, and the highest electron concentration can be close to the doping concentration in the CO material (e.g., approximately 1×10²⁰/cm³). As shown in FIG. 6A, there is band bending at the QTB/Si interface, pushing the Fermi level closer to the conduction band edge (E_{c}) of the c-Si. Because the band offset between the Si and the TCO can be fairly small, and considering the thermal broadening, the tunneling effect can be strong.

FIG. 6B shows the band diagram at the interface between c-Si and a CO material with a work function considerably smaller than the c-Si conduction band edge, according to an embodiment of the present invention. In FIG. 6B, the work function of the CO material is considerably smaller than the c-Si conduction band edge. At the QTB/Si interface, the slope for the band bending can be sufficiently big that a quantum well for electrons appears, while the triangular-shaped quantum barrier can be just a few nanometers thick. As a result, the lowest energy level for the heavily degenerated electrons on the Si side is not at the conduction band edge, but is the first confinement energy level, which can be within 0.1 eV from the conduction band edge (as shown by the dots in FIG. 6B). Therefore, there could be no obvious energy level offset for the intra-band tunneling of the electrons. Holes, on the other hand, can be repelled by the potential barrier.

FIG. 6C shows the band diagram at the interface between c-Si and a CO material with a work function slightly larger than the c-Si conduction band edge, according to an embodiment of the present invention. In FIG. 6C, the work function of the CO material is larger than the E_{c} of c-Si by about 0.05-0.15 eV. Electrons with energy levels starting from the conduction band edge E_{c} will enter from the c-Si side to the unfilled conduction band of the CO. There will be fewer electrons transferring from the CO side to the c-Si side due to the potential difference. As a result, the electron concentration at the QTB/Si interface will be less than, for example, 1×10¹⁸/cm³. Hence, there might not be sufficient band bending at the interface and the passivation is compromised. To improve the passivation, one can apply shallow n-type doping at the surface of the c-Si substrate. Note that, in order to minimize undesired absorption of short wavelength light, the shallow doping ideally has a peak concentration of at least 1×10¹⁹/cm³ and a depth of less than or equal to 100 nm.

In one embodiment, the low work function CO material has a work function of less than or equal to 4.2 eV. Examples of low work function CO materials include, but are not limited to: aluminum doped zinc oxide (AZO), tungsten doped indium oxide (IWO), Sn doped indium oxide (ITO), fluorine doped tin oxide (F:SnO₂), zinc doped indium oxide (IZO), zinc and tungsten doped indium oxide (IZWO), and their combinations. Note that the work function of most CO materials can be tuned by adjusting the carrier concentration and doping. In addition, one can control the CO work function by controlling the crystalline orientation and surface condition. Similar to the deposition of high work function CO material, the low work function CO material can be deposited using a low-damage deposition method. Examples of low-damage deposition methods include, but are not limited to: radio frequency (RF) sputtering, thermal evaporation, epitaxial growth such as molecular beam epitaxy (MBE) and metalorganic chemical-vapor deposition (MOCVD), atomic layer deposition (ALD), remote plasma deposition, and ion plating deposition (IPD). In one embodiment, the Dᵢₜ at the interface can be less than 1×10¹¹/cm², which can ensure sufficient surface passivation.

In some embodiments, instead of replacing both the p-type and n-type doped a-Si with low work function and high work function CO materials, respectively, one could replace only the p-type doped a-Si with the low work function CO material, or replace only the n-type doped a-Si with the high work function CO material. Moreover, it is also possible to not include the intrinsic a-Si layer (layer 310 or 410) in the TIBC solar cell by direct depositing the a-Si emitters or CO emitters onto the back side QTB layer.

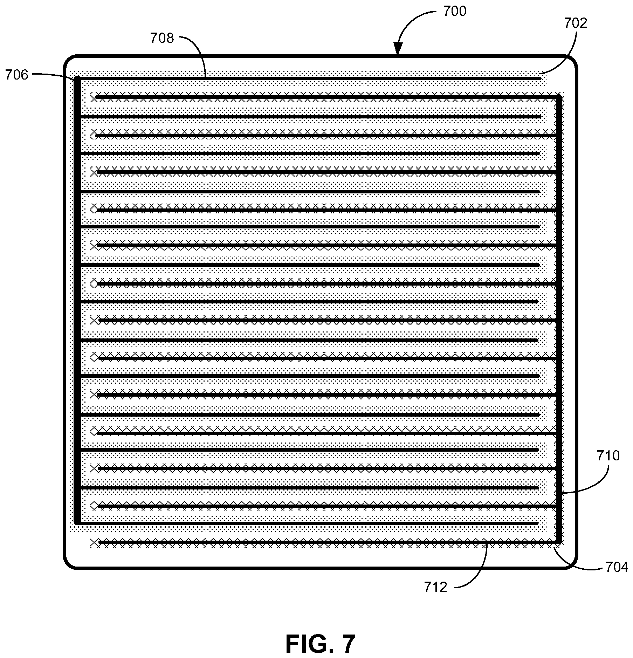

FIG. 7 shows an exemplary IBC solar cell layout according to one embodiment of the present invention. In this example, solar cell 700 has a lightly n-type doped c-Si base layer, and on the back side there are two regions: a high work function TCO region 702 (shown in dotted pattern) as a hole collector and a low work function TCO region 704 (shown in crosshatched pattern) as an electron collector. Both regions are configured in a finger-line pattern, and the fingers are interleaved, forming an interdigitated pattern. Metallic electrodes, such as electrodes 708 and 712, can be formed on each region, respectively. In one embodiment, the width of each electrode can be less than the width of the corresponding TCO finger to reduce shading. In each region (i.e., the electron collector region or hole collector region), the metallic finger lines are connected with a busbar, which is placed near an edge of the solar cell. Because of the transparent nature of TCO, and because the metallic electrodes only cover a portion of the back side, light can pass through the back side and reach the base layer, thereby allowing solar cell to operate in a bi-facial mode.

In a further embodiment, the electron collector and hole collector can be formed using opaque CO materials with different work functions. Alternatively, the electron collector and hole collector can be formed using p-type doped a-Si and n-type doped a-Si, respectively. These two regions can then be covered by the same transparent or opaque CO material.

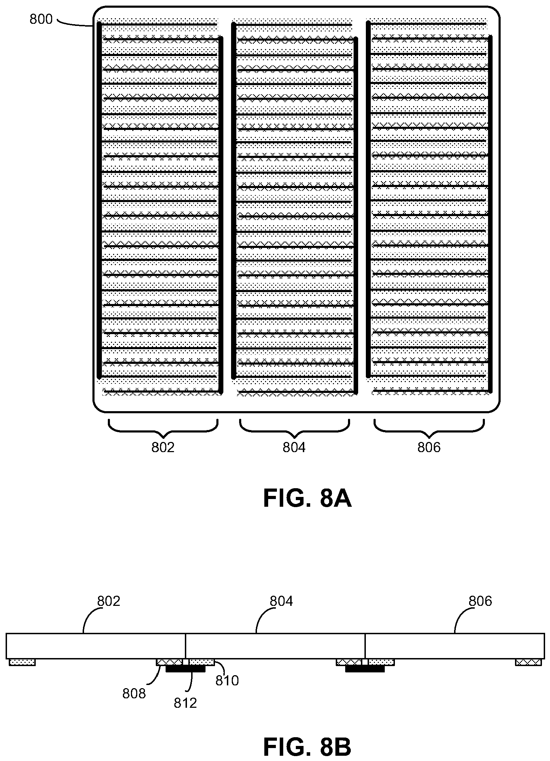

FIG. 8A shows another IBC solar cell layout according to an embodiment of the present invention. In this example, conventional square or pseudo square shaped cell 800 can be divided into three strips 802, 804, and 806. Each strip has an IBC configuration similar to that of solar cell 700 shown in FIG. 7. In one embodiment, multiple such strips can be cascaded into a string, which can have the same output voltage as a conventional solar panel that has the square or pseudo square shaped solar cells connected in series in a single string. Multiple cascaded strings formed with these strips can then be connected in parallel within a single panel. Consequently, the total internal resistance of the entire solar panel can be significantly reduced, and the panel's output power can be increased correspondingly. More details of such cascaded (also referred to as "shingled") configuration can be found in U.S. Patent Application No. 14/563,867, Attorney Docket Number P67-3US, entitled "HIGH EFFICIENCY SOLAR PANEL," by inventors Bobby Yang, Peter P. Nguyen, Jiunn Benjamin Heng, Anand J. Reddy, and Zheng Xu, the disclosure of which is incorporated by reference herein in its entirety.

FIG. 8B shows an exemplary cascaded configuration of solar cell strips with IBC, according to one embodiment of the present invention. In this example, three strips 802, 804, and 806 are cascaded in series along their long edges. Because each strip's busbars are both on the back side, and the busbars of opposite polarity are positioned on opposing edges, the strips can be placed next to each other, and the adjacent busbars from two neighboring strips are of opposite polarities. For example, strip 802's positive busbar 808 can be placed next to strip 804's negative busbar 810. In one embodiment, metallic tab 812 can be used to connect busbars 808 and 810, thereby forming a series connection between strip 802 and 804. In one embodiment, the strips can be placed close to each other to reduce the gap between them. Other methods can also be used to connect two adjacent busbars. For example, a conductive adhesive paste can be applied on busbars 808 and 810 to connect them.

### Fabrication Method

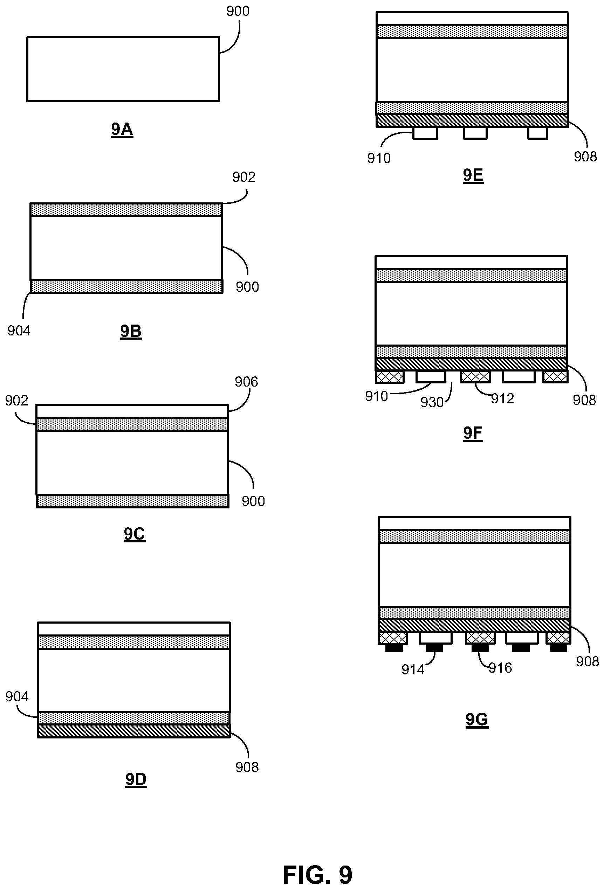

Either n- or p-type doped high-quality solar-grade silicon (SG-Si) wafers can be used to fabricate the TIBC solar cell. FIG. 9 shows an exemplary process of fabricating a TIBC solar cell, according to an embodiment of the present invention.

In operation 9A, an SG-Si substrate can be prepared to form a base layer 900. The resistivity of the SG-Si substrate can be in, but not limited to, the range between 1 ohm-cm and 10 ohm-cm. In one embodiment, the resistivity of the SG-Si substrate can be between 1 ohm-cm and 6 ohm-cm. Base layer 900 can include a c-Si wafer that is cut from an ingot obtained using the CZ/FZ process. In some embodiments, base layer 900 can have a thickness ranging from 80 µm to 200 µm. The preparation operation can include saw-damage etching that removes approximately 10-30 µm of silicon. In one embodiment, surface texturing can also be performed to create a random pyramid textured surface. Subsequently, the SG-Si substrate can undergo surface cleaning. In addition, base layer 900 can also be formed using an epitaxial process (such as MOCVD), where a c-Si epitaxial film can be grown on and then removed from a growth substrate. In one embodiment, base layer 900 can be lightly doped with a doping concentration that ranges between 5×10¹⁴/cm³ and 1×10¹⁶/cm³.

In operation 9B, a thin layer of high-quality (with Dᵢₜ less than 1×10¹¹/cm²) dielectric material can be formed on the front and back surfaces of base layer 900 to form front-side QTB layer 902 and back side QTB layer 904. Various types of dielectric materials can be used to form the QTB layers, including, but not limited to: silicon oxide (SiOₓ, including silicon dioxide and silicon monoxide), hydrogenated SiOₓ, silicon nitride (SiNₓ), hydrogenated SiNₓ, silicon oxynitride (SiON), hydrogenated SiON, aluminum oxide (AlOₓ), and aluminum nitride (AlNₓ). In one embodiment, back side QTB layer 904 can include SiOₓ and/or hydrogenated SiOₓ. Various techniques can be used to form such oxide layers, including, but not limited to: submerging the substrate in hot deionized water (DIW), low-pressure radical oxidation, ozone oxygen oxidation, atomic oxygen oxidation, thermal oxidation, chemical oxidation, steam or wet oxidation, atomic layer deposition, ozone bubbling in DIW, and/or plasma-enhanced chemical-vapor deposition (PECVD). The thickness of the QTB layers can be between 1 and 20 Å. In some embodiments, in addition to dielectric material, a variety of wide bandgap semiconductor materials, such as
a-Si, hydrogenated a-Si, carbon doped a-Si, and SiC, can also be used to form front QTB layer 902. In some embodiments, the Dᵢₜ of QTB layers 902 and 904 can be less than 5×10¹¹ /*cm².*

In operation 9C, anti-reflection coating (ARC) layer 906 can be formed on QTB layer 902. In some embodiments, ARC layer 906 can include one or more of: a TCO material, SiNₓ, SiOₓ, and AlₓO₃. The thickness of ARC layer 906 can be approximately 100 nm.

In operation 9D, which can be optional, intrinsic a-Si layer 908 can be formed on back side QTB layer 904. Such intrinsic a-Si layer 908 can improve passivation and facilitate isolation between the n and p emitters. In some embodiments, the thickness of intrinsic a-Si layer 908 can range from 5 Å to 100 Å. In a further embodiment, the thickness of intrinsic a-Si layer 908 is approximately 30 Å. Intrinsic a-Si layer 908 can be formed using a plasma-enhanced chemical-vapor deposition (PECVD) technique.

In operation 9E, a first emitter layer (n or p), such as emitter 910, can be deposited on intrinsic a-Si layer 908. This emitter layer, together with a subsequently formed second emitter layer of an opposite polarity, can form an interdigitated pattern. In some embodiments, the emitters can include an a-Si layer with graded doping. The electrical conductivity type of the emitters can be opposite to that of base layer 900. In further embodiments, the graded doped a-Si emitters can have a thickness between 1 and 20 nm, and the doping concentration of the graded doped a-Si can be between 1×10¹⁵ /*cm*³ and 5×10²⁰ / *cm³ .* In some embodiments, the emitters may include a conducting oxide (CO) material with an appropriate work function. For example, CO material with a high work function can include but is not limited to: tungsten doped indium oxide (IWO), Sn doped indium oxide (ITO), GaInO (GIO), GaInSnO (GITO), ZnInO (ZIO), ZnInSnO (ZITO),WOₓ, ITiOₓ, MnOₓ, InO, CeOₓ and their combinations. Preferably, the work function of the CO can be at least 5.0 eV. In further embodiments, the CO material can have a work function greater than the energy level of c-Si valence band edge. To facilitate an interdigitated pattern, a process that involves masking, material deposition (which can involve PECVD or PVD), and mask removal can be used. Note that because these emitters are located on the back side of solar cell 900, they are no required to be transparent.

In operation 9F, a second emitter layer of an opposite polarity, such as emitter 912, can be formed on intrinsic a-Si layer 908. The second emitter layer interleaves with the first emitter layer formed in operation 9F, thereby forming an interdigitated pattern. In some embodiments, the second emitter layer can include an a-Si layer with graded doping. In further embodiments, the second emitter layer can have a thickness between 1 and 30 nm, and, if graded doped a-Si is used as this second emitter layer, the doping concentration of the graded doped a-Si can be between 1×10¹⁵ /*cm*³ and 5×10²⁰ /*cm*³*.* In some embodiments, the second emitter layer may be a CO material with appropriate work functions. For example, the second emitter layer can include a low work function TCO material, including but not limited to: aluminum doped zinc oxide (AZO), tungsten doped indium oxide (IWO), Sn doped indium oxide (ITO), fluorine doped tin oxide (F:SnO₂), zinc doped indium oxide (IZO), zinc and tungsten doped indium oxide (IZWO), and their combination. In further embodiments, the low work function TCO can have a work function that is less than 4.2 eV. To form the interdigitated pattern, a process that involves masking, material deposition, and mask removal can be used. The masks used for depositing the two emitter layers can be designed in such a way that adjacent emitter regions of opposite polarities are separated by a gap. For example, emitter 910 and emitter 912 are separated by gap 930.

In another embodiment, emitter 910 can be deposited as a blanket layer and emitter 912 can be deposited in selected regions such that portions of emitter 910 under emitter 912 can become counter doped to have effectively the same doping type as emitter 912, especially after a thermal process that can result in diffusion of dopants.

It is possible to have one type of emitter formed with doped a-Si and the other type of emitter formed with a CO material with appropriate work function, and vice versa. In one example, base layer 900 can be p-type doped, the p emitter can be n-type doped a-Si, and n emitter can include a high work function CO material. In another example, base layer 900 can be p-type doped, the p emitter can be a low work function CO material, and the n emitter can be p-type doped a-Si. In a further example, base layer 900 can be n-type doped, the n emitter can be p-type doped a-Si, and the p emitter can include a low work function CO material. In yet another example, base layer 900 can be n-type doped, the n emitter can be a high work function CO material, and p emitter can be n-type doped a-Si.

In operation 9G, back side electrodes, such as electrodes 914 and 916 are formed on the n and p emitter regions. The electrodes may include one or more metallic layers and a CO layer. If the two types of emitters are made of doped a-Si, the electrodes may include a layer of CO to facilitate ohmic contacts. On the other hand, if the emitters are formed using CO materials, no additional CO layer will be needed. In some embodiments, the metallic layers can be formed using various techniques, including but not limited to screen printing, evaporating, inkjet printing, aerosol printing, and electro- or electroless plating. In some embodiments, the metallic layers can include a Cu grid formed using various techniques, including, but not limited to: electroless plating, electroplating, sputtering, and evaporation.

The foregoing descriptions of various embodiments have been presented only for purposes of illustration and description. They are not intended to be exhaustive or to limit the present invention to the forms disclosed. Accordingly, many modifications and variations, which are within the scope of the appended claims, will be apparent to practitioners skilled in the art. Additionally, the above disclosure is not intended to limit the present invention.

## Claims

1. A solar cell, comprising:
a crystalline silicon base layer;
an electron collector region on a back side of the base layer, the electron collector region comprising a first conductive oxide material electrically coupled to the base layer; and
a hole collector region on the back side of the base layer, the hole collector region comprising a second conductive oxide material electrically coupled to the base layer;
wherein the electron collector region and hole collector region form an interdigitated pattern; and
wherein the first conductive oxide material and second conductive oxide material have different work functions.

2. The solar cell of claim 1, further comprising a quantum-tunneling-barrier layer between the base layer and the electron collector region.

3. The solar cell of claim 2, further comprising an intrinsic amorphous silicon layer between the quantum-tunneling-barrier layer and the electron collector region.

4. The solar cell of claim 1, wherein the electron collector region or hole collector region does not contain doped amorphous silicon.

5. The solar cell of claim 1, wherein at least one of the first conductive oxide material and second conductive oxide material is transparent.

6. The solar cell of claim 1, wherein the base layer is doped with p-type dopants, and wherein the first conductive oxide material has a work function that is less than or equal to 4.2 eV.

7. The solar cell of claim 6, wherein the first conducting oxide material includes at least one material selected from a group consisting of:
aluminum doped zinc oxide;
tungsten doped indium oxide;
tin doped indium oxide;
fluorine doped tin oxide;
zinc doped indium oxide; and
zinc and tungsten doped indium oxide.

8. The solar cell of claim 1, wherein the base layer is doped with n-type dopants, and wherein the first conductive oxide material has a work function that is greater than or equal to 5.0 eV.

9. The solar cell of claim 8, wherein the first conducting oxide material includes at least one material selected from a group consisting of:
tungsten doped indium oxide;
tin doped indium oxide;
gallium indium oxide;
gallium indium tin oxide;
zinc indium oxide;
zinc indium tin oxide;
titanium doped indium oxide;
cerium oxide;
tungsten oxide;
manganese oxide; and
indium oxide.

10. A photovoltaic structure, comprising:
a crystalline silicon base layer;
a first transparent conductive oxide region; and
a second transparent conductive oxide region;
wherein the first transparent conductive oxide region and second transparent conductive oxide region are positioned on a same side of the base layer and form an interdigitated pattern; and
wherein the first transparent conductive oxide region and second transparent conductive oxide region have different work functions.

11. The photovoltaic structure of claim 10, wherein the first transparent conductive oxide region and second transparent conductive oxide region are coupled to the base layer without doped amorphous silicon.

12. The photovoltaic structure of claim 10, further comprising:
an first electrode coupled to and partially covering the first transparent conductive oxide region; and
a second electrode coupled to and partially covering the second transparent conductive oxide region.

13. The photovoltaic structure of claim 10, wherein the first transparent conductive oxide region and second transparent conductive oxide region are coupled to the base layer via a quantum-tunneling-barrier layer and an intrinsic amorphous silicon layer.

14. The photovoltaic structure of claim 10, wherein the base layer is doped with p-type dopants, and the first conductive oxide has a work function that is less than or equal to 4.2 eV.

15. The photovoltaic structure of claim 10, wherein the base layer is doped with n-type dopants, and the first conductive oxide has a work function that is greater than or equal to 5.0 eV.

## Patentansprüche

1. Solarzelle, umfassend:
eine Basisschicht aus kristallinem Silicium,
einen Elektronensammelbereich auf einer Rückseite der Basisschicht, wobei der Elektronensammelbereich ein erstes leitfähiges Oxidmaterial umfasst, das mit der Basisschicht elektrisch gekoppelt ist; und
einen Lochsammelbereich auf der Rückseite der Basisschicht, wobei der Lochsammelbereich ein zweites leitfähiges Oxidmaterial umfasst, das mit der Basisschicht elektrisch gekoppelt ist;
wobei der Elektronensammelbereich und der Lochsammelbereich ein Interdigitalmuster bilden; und
wobei das erste leitfähige Oxidmaterial und das zweite leitfähige Oxidmaterial verschiedene Arbeitsfunktionen aufweisen.

2. Solarzelle nach Anspruch 1, ferner umfassend eine Quantentunnelbarriereschicht zwischen der Basisschicht und dem Elektronensammelbereich.

3. Solarzelle nach Anspruch 2, ferner umfassend eine Schicht aus intrinsischem amorphem Silicium zwischen der Quantentunnelbarriereschicht und dem Elektronensammelbereich.

4. Solarzelle nach Anspruch 1, wobei der Elektronensammelbereich oder Lochsammelbereich kein dotiertes amorphes Silicium enthält.

5. Solarzelle nach Anspruch 1, wobei das erste leitfähige Oxidmaterial und/oder das zweite leitfähige Oxidmaterial transparent sind/ist.

6. Solarzelle nach Anspruch 1, wobei die Basisschicht mit Dotierstoffen vom p-Typ dotiert ist und wobei das erste leitfähige Oxidmaterial eine Arbeitsfunktion aufweist, die kleiner oder gleich 4,2 eV ist.

7. Solarzelle nach Anspruch 6, wobei das erste leitfähige Oxidmaterial mindestens ein Material aus der Gruppe bestehend aus
aluminiumdotiertem Zinkoxid;
wolframdotiertem Indiumoxid;
zinndotiertem Indiumoxid;
fluordotiertem Indiumoxid;
zinkdotiertem Indiumoxid und
zink- und wolframdotiertem Indiumoxid enthält.

8. Solarzelle nach Anspruch 1, wobei die Basisschicht mit Dotierstoffen vom n-Typ dotiert ist und wobei das erste leitfähige Oxidmaterial eine Arbeitsfunktion aufweist, die größer oder gleich 5,0 eV ist.

9. Solarzelle nach Anspruch 8, wobei das erste leitfähige Oxidmaterial mindestens ein Material aus der Gruppe bestehend aus
wolframdotiertem Indiumoxid;
zinndotiertem Indiumoxid;
Galliumindiumoxid;
Galliumindiumzinnoxid;
Zinkindiumoxid;
Zinkindiumzinnoxid;
titandotiertem Indiumoxid;
Ceroxid;
Wolframoxid;
Manganoxid und
Indiumoxid
enthält.

10. Photovoltaikstruktur, umfassend:
eine Basisschicht aus kristallinem Silicium;
einen Bereich aus einem ersten transparenten leitfähigen Oxid und
einen Bereich aus einem zweiten transparenten leitfähigen Oxid;
wobei der Bereich aus einem ersten transparenten leitfähigen Oxid und der Bereich aus einem zweiten transparenten leitfähigen Oxid auf einer gleichen Seite der Basisschicht angeordnet sind und ein Interdigitalmuster bilden; und
wobei der Bereich aus einem ersten transparenten leitfähigen Oxid und der Bereich aus einem zweiten transparenten leitfähigen Oxid verschiedene Arbeitsfunktionen aufweisen.

11. Photovoltaikstruktur nach Anspruch 10, wobei der Bereich aus einem ersten transparenten leitfähigen Oxid und der Bereich aus einem zweiten transparenten leitfähigen Oxid ohne dotiertes amorphes Silicium an die Basisschicht gekoppelt sind.

12. Photovoltaikstruktur nach Anspruch 10, ferner umfassend:
eine erste Elektrode, die an den Bereich aus einem ersten transparenten leitfähigen Oxid gekoppelt ist und diesen teilweise bedeckt; und
eine zweite Elektrode, die an den Bereich aus einem zweiten transparenten leitfähigen Oxid gekoppelt ist und diesen teilweise bedeckt.

13. Photovoltaikstruktur nach Anspruch 10, wobei der Bereich aus einem ersten transparenten leitfähigen Oxid und der Bereich aus einem zweiten transparenten leitfähigen Oxid über eine Quantentunnelbarriereschicht und eine Schicht aus intrinsischem amorphem Silicium an die Basisschicht gekoppelt sind.

14. Photovoltaikstruktur nach Anspruch 10, wobei die Basisschicht mit Dotierstoffen vom p-Typ dotiert ist und das erste leitfähige Oxid eine Arbeitsfunktion aufweist, die kleiner oder gleich 4,2 eV ist.

15. Photovoltaikstruktur nach Anspruch 10, wobei die Basisschicht mit Dotierstoffen vom n-Typ dotiert ist und das erste leitfähige Oxid eine Arbeitsfunktion aufweist, die größer oder gleich 5,0 eV ist.

## Revendications

1. Cellule solaire, comprenant :
une couche de base en silicium cristallin ;
une région collectrice d'électrons sur un côté arrière de la couche de base, la région collectrice d'électrons comprenant un premier matériau à base d'oxyde conducteur couplé électriquement à la couche de base ; et
une région collectrice de trous sur le côté arrière de la couche de base, la région collectrice de trous comprenant un deuxième matériau à base d'oxyde conducteur couplé électriquement à la couche de base ;
dans laquelle la région collectrice d'électrons et la région collectrice de trous forment un motif interdigité ; et
dans laquelle le premier matériau à base d'oxyde conducteur et le deuxième matériau à base d'oxyde conducteur ont des travaux d'extraction différents.

2. Cellule solaire de la revendication 1, comprenant en outre une couche barrière à effet tunnel quantique entre la couche de base et la région collectrice d'électrons.

3. Cellule solaire de la revendication 2, comprenant en outre une couche de silicium amorphe intrinsèque entre la couche barrière à effet tunnel quantique et la région collectrice d'électrons.

4. Cellule solaire de la revendication 1, dans laquelle la région collectrice d'électrons ou la région collectrice de trous ne contient pas de silicium amorphe dopé.

5. Cellule solaire de la revendication 1, dans laquelle le premier matériau à base d'oxyde conducteur et/ou le deuxième matériau à base d'oxyde conducteur sont transparents.

6. Cellule solaire de la revendication 1, dans laquelle la couche de base est dopée avec des dopants de type p, et dans laquelle le premier matériau à base d'oxyde conducteur a un travail d'extraction qui est inférieur ou égal à 4,2 eV.

7. Cellule solaire de la revendication 6, dans laquelle le premier matériau à base d'oxyde conducteur comporte au moins un matériau choisi dans le groupe constitué par :
l'oxyde de zinc dopé à l'aluminium ;
l'oxyde d'indium dopé au tungstène ;
l'oxyde d'indium dopé à l'étain ;
l'oxyde d'étain dopé au fluor ;
l'oxyde d'indium dopé au zinc ; et
l'oxyde d'indium dopé au zinc et au tungstène.

8. Cellule solaire de la revendication 1, dans laquelle la couche de base est dopée avec des dopants de type n, et dans laquelle le premier matériau à base d'oxyde conducteur a un travail d'extraction qui est supérieur ou égal à 5,0 eV.

9. Cellule solaire de la revendication 8, dans laquelle le premier matériau à base d'oxyde conducteur comporte au moins un matériau choisi dans un groupe constitué par :
l'oxyde d'indium dopé au tungstène ;
l'oxyde d'indium dopé à l'étain ;
l'oxyde de gallium-indium ;
l'oxyde de gallium-indium-étain ;
l'oxyde de zinc-indium ;
l'oxyde de zinc-indium-étain ;
l'oxyde d'indium dopé au titane ;
l'oxyde de cérium ;
l'oxyde de tungstène ;
l'oxyde de manganèse ; et
l'oxyde d'indium.

10. Structure photovoltaïque, comprenant :
une couche de base en silicium cristallin ;
une première région d'oxyde conducteur transparent ; et
une deuxième région d'oxyde conducteur transparent ;
dans laquelle la première région d'oxyde conducteur transparent et la deuxième région d'oxyde conducteur transparent sont positionnées sur un même côté de la couche de base et forment un motif interdigité ; et
dans laquelle la première région d'oxyde conducteur transparent et la deuxième région d'oxyde conducteur transparent ont des travaux d'extraction différents.

11. Structure photovoltaïque de la revendication 10, dans laquelle la première région d'oxyde conducteur transparent et la deuxième région d'oxyde conducteur transparent sont couplées à la couche de base sans silicium amorphe dopé.

12. Structure photovoltaïque de la revendication 10, comprenant en outre :
une première électrode couplée à et recouvrant partiellement la première région d'oxyde conducteur transparent ; et
une deuxième électrode couplée à et recouvrant partiellement la deuxième région d'oxyde conducteur transparent.

13. Structure photovoltaïque de la revendication 10, dans laquelle la première région d'oxyde conducteur transparent et la deuxième région d'oxyde conducteur transparent sont couplées à la couche de base par le biais d'une couche barrière à effet tunnel quantique et une couche de silicium amorphe intrinsèque.

14. Structure photovoltaïque de la revendication 10, dans laquelle la couche de base est dopée avec des dopants de type p, et le premier oxyde conducteur a un travail d'extraction qui est inférieur ou égal à 4,2 eV.

15. Structure photovoltaïque de la revendication 10, dans laquelle la couche de base est dopée avec des dopants de type n, et le premier oxyde conducteur a un travail d'extraction qui est supérieur ou égal à 5,0 eV.
